# EUROPÄISCHE PATENTANMELDUNG

(11) **EP 1 641 121 A2**
(43) Veröffentlichungstag der Anmeldung: **29.03.2006**
(21) Anmeldenummer: 05018508.1
(22) Anmeldetag: 25.08.2005
(51) Int. Cl.: H03K 3/03

(54) **Verfahren und Schaltungsanordnung zur Unterdrückung von Schwingungsmoden in Ringoszillatoren**

(30) Priorität: 23.09.2004 DE 102004046519
(71) Anmelder: Micronas GmbH, 79108 Freiburg i. Br. (DE)
(72) Erfinder: Bidenbach, Reiner, 79279 Vörstetten (DE); Theus, Ulrich, 79194 Gundelfingen (DE); Gehrig, Wilfried, 79232 March (DE)
(74) Vertreter: Mussgnug, Bernd

(57) **Zusammenfassung**

Die Erfindung betrifft ein Verfahren sowie eine Schaltungsanordnung zur Unterdrückung von Schwingungsmoden, insbesondere von Schwingungsmoden höherer Ordnung, in einem Ringoszillator (3) mit über Knoten (K₀, K₁, ... Kᵢ ... Kₖ ... Kₘ ... Kₙ₋₁) verbundenen, einen Oszillatorring bildenden Verzögerungselementen (V₀, V₁, ... Vⱼ...Vₖ...Vₘ...Vₙ₋₁, TVₙ₋₁) und mit einem in dem Oszillatorring angeordneten Torelement (T, TVₙ₋₁), welches mittels eines Steuersignals (S) zum Öffnen oder Schließen des Torelements (T, TVₙ₋₁) angesteuert wird. Erfindungsgemäß ist vorgesehen, das Steuersignal (S) aus wenigstens einem der an den Knoten (K₀, K₁, ... Kⱼ...Kₖ...Kₘ...Kₙ₋₁) anliegenden Pegeln eines Oszillatorsignals abzuleiten. Die erfindungsgemäße Schaltungsanordnung weist zu diesem Zweck eine entsprechend dieser Funktionalität ausgebildete Torsteuereinrichtung auf.

## Beschreibung

Die Erfindung betrifft ein Verfahren zur Unterdrückung von Schwingungsmoden, insbesondere von Schwingungsmoden höherer Ordnung, in einem Ringoszillator gemäß dem Oberbegriff des Patentanspruchs 1. Weiterhin betrifft die Erfindung eine Schaltungsanordnung zur Unterdrückung von Schwingungsmoden, insbesondere von Schwingungsmoden höherer Ordnung, in einem Ringoszillator gemäß dem Oberbegriff des Patentanspruchs 10.

Insbesondere zur Gewinnung verschiedener Signalphasenlagen werden in einigen Bereichen lange Ringoszillatoren eingesetzt. "Lang" meint in diesem Fall, dass wesentlich mehr als die mindestens drei benötigten Verzögerungsstufen zum Einsatz kommen. Einen derartigen Ringoszillator 1 gemäß dem Stand der Technik mit einer Anzahl n von verzvgerungsstufen V₀, V₁, V₂, ... Vₘ..., Vₙ₋₁, deren Eingänge über entsprechende Knoten K₀, K₁, K₂,... Kₘ,... Kₙ₋₁, mit den Ausgängen der jeweils nachfolgenden Verzögerungsstufen V₀, V₁, V₂, ... Vₘ, ... Vₙ₋₁ verbunden sind, ist in der Zeichnungsfigur 3 dargestellt.

Soll die Schwingungsfrequenz der Grundschwingung des Ringoszillators variabel sein, so werden in ihrer verzögerungszeit steuerbare Verzögerungselemente verwendet. Ist die Verzögerungszeit durch eine Steuerspannung veränderbar, so bildet diese Konstellation einen spannungsgeregelten Oszillator (VCO = Akronym für Voltage Controlled Oscillator oder Varactor Controlled Oscillator)zur Erzeugung einer Grundschwingung, die zu einem zugeführten Referenzsignal phasenstarr ist, wird der VCO in eine Phasenregelschleife (PLL = Akronym für Phase Locked Loop) eingebettet.

An jedem Verzögerungselement kann ein Signal mit einer definierten Phasenlage abgegriffen werden. Um eine maximale Symmetrie und damit eine minimale Abweichung der Phasenlagen von ihrem Sollwert zu gewährleisten, werden die Verzögerungselemente und deren Verbindungen möglichst gleichartig ausgeführt.

Während des Einschaltens der Betriebsspannung haben die Ein- und Ausgänge der Verzögerungselemente einen undefinierten Zustand. Erreicht die Betriebsspannung einen bestimmten Wert, so fangen die Verzögerungselemente an normal zu arbeiten. D. h., das Ausgangssignal leitet sich nach einer Zeitverzögerung aus dem Eingangssignal ab. Bevorzugt stellt das Ausgangssignal der Verzögerungsstufe deren invertiertes Eingangssignal dar. Wegen des zu Beginn undefinierten Zustands aller Verzögerungselemente breiten sich viele dynamische Signalübergänge aus. D.h., an mehreren Stellen des Oszillatorrings führt der Eingangspegel der Verzögerungselemente nach einer Verzögerung zu einer Änderung des Ausgangspegels.

In idealen Systemen würde dieser Zustand endlos andauern. In realen Systemen mit analogen Verzögerungselementen führen vorauseilende Übergänge dazu, dass nachfolgende Übergänge eine etwas kürzere Laufzeit durch die Verzögerungselemente haben. Dies kommt durch den endlichen Innenwiderstand, mit dem die elektrischen Ein- und Ausgangsknoten umgeladen werden. Dieser Innenwiderstand führt dazu, dass die Spannungsdifferenz der zwei unterschiedlichen Endzustände eines nachfolgenden Übergangs geringer wird und somit die Ausgänge der Verzögerungselemente ihren Zustand schneller wechseln können. Somit holt ein nachfolgender Übergang den vorauseilenden Übergang nach einigen Umläufen im Oszillatorring ein und löscht sich dann mit diesem aus ("Sogeffekt"). Dies passiert so lange, bis nur noch ein Übergang im Ring existiert. Dies ist bei allen Ringen mit einer ungeraden Anzahl von invertierenden Verzögerungselementen der Fall.

In realen Oszillatorringen kann es jedoch zu Kopplungseffekten kommen, die der Aufeinanderzubewegung der Übergänge entgegenwirkt. In diesem Fall überwiegt der oben genannte Beschleunigungseffekt nachfolgender Übergänge nur bei einer begrenzten Anzahl nachfolgender verzögerungselemente.

Somit bleibt eine ungerade Anzahl größer eins von Übergängen im Oszillatorring dauerhaft erhalten. Dies führt zu unbestimmten Frequenzen oder Phasenlagen am Ausgang der Verzögerungselemente. Eine detaillierte Abhandlung der vorstehend beschriebenen Phänomene ist z.B. den Aufsätzen von Yasuo Arai "TMC304 (TMC-TEG3) Trouble Report" vom 22.04.1996 und vom 31.05.1996 in KEK Research Japan (National High Energy Accelerator Research Organisation), Seiten 1 bis 8 zu entnehmen.

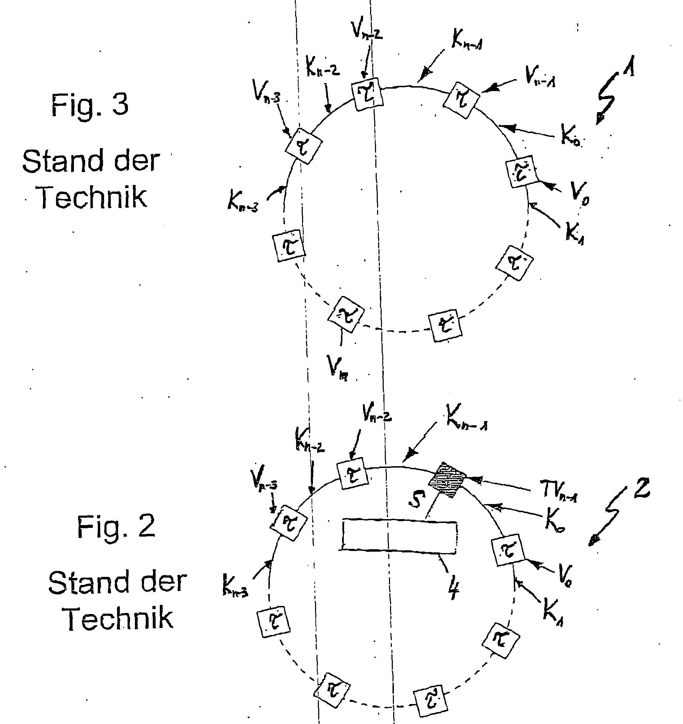

Dem kann entgegen gewirkt werden, indem der Lehre aus "Ring Oscillator Design, Test and Applications" in Keithley Waferline Summer 2000, Seiten 2 bis 5 folgend in den Oszillatorring ein Tor eingebaut wird, das am Ausgang einen definierten Pegel liefert, unabhängig vom Eingang. Einen derartigen Ringoszillator 2 mit über Knoten K₀, K₁, K₂,... Kₘ,... Kₙ₋₁ verbundenen, einen Oszillatorring bildenden Verzögerungselementen V₀, V₁, V₂, ... Vₘ, ... Vₙ₋₁ und mit einem kombinierten Verzögerungs-/Torelement TVₙ₋₁ gemäß dem Stand der Technik entnimmt man z.B. der Figur 2.

Erst nach dem Erreichen der zur Funktion notwendigen Betriebsspannung wird das gegebenenfalls mit einem Verzögerungselement kombinierte Tor _{Tvn}-l geöffnet und der Ausgang ändert seinen Pegel in Abhängigkeit des Eingangs. Dies ist aber nur machbar, wenn ein entsprechendes Steuersignal S zur Verfügung steht, was im Ausführungsbeispiel gemäß der Figur 2 von einer Torsteuereinrichtung 4 bereitgestellt wird.

Aus dem betriebsinternen Stand der Technik ist es bekannt, ein externes Steuersignal mit Hilfe eines Komparators zu erzeugen, der die Betriebsspannung des Ringoszillators mit einer Referenzspannung vergleicht, bei der alle Verzögerungselemente voll funktionsfähig sind.

Obwohl sich diese Ansteuerung des Tors in dem Ringoszillator dem Grunde nach bewährt hat, werden dadurch nicht zwangsläufig sämtliche unerwünschte Schwingungsmoden, insbesondere Moden höherer Ordnung, während des Betriebs z. B. durch Störeinflüsse wie Betriebsspannungsschwankungen, hochfrequente oder radioaktive Strahlung, eliminiert.

Der Erfindung liegt daher die Aufgabe zugrunde, ein Verfahren und eine Schaltungsanordnung zur Unterdrückung von unerwünschten Schwingungsmoden in Ringoszillatoren bereitzustellen.

Diese Aufgabe wird durch ein verfahren mit den Merkmalen des Patentanspruchs 1 sowie durch eine Schaltungsanordnung mit den Merkmalen des Patentanspruchs 10 erfindungsgemäß gelöst.

Vorteilhafte Ausführungen und Weiterbildungen der Erfindung sind in den Unteransprüchen angegeben.

Die Erfindung basiert auf der Idee, dass ein aus den Pegeln des Oszillatorrings gewonnenes Signal das oben erwähnte Tor steuert. Das Steuersignal hat so auszusehen, dass durch das Tor der normale Schwingungsmode, nämlich die Grundschwingung und/oder eine andere gewünschte Schwingung höherer Ordnung, nicht beeinflusst wird. Jedoch sollen alle anderen (unerwünschten) Schwingungsmoden, vorzugsweise alle höheren Schwingungsmoden im Falle der die normale Schwingungsmode darstellenden Grundschwingung, wirksam unterdrückt werden.

Ausgehend von einem Verfahren zur Unterdrückung von Schwingungsmoden, insbesondere von Schwingungsmoden höherer Ordnung, in Ringoszillatoren mit über Knoten verbundenen, einen Oszillatorring bildenden Verzögerungselementen und mit einem in dem Oszillatorring angeordneten Torelement, welches mittels eines Steuersignals zum Öffnen oder Schließen des Torelements angesteuert wird, ist erfindungsgemäß vorgesehen, dass das Steuersignal aus wenigstens einem der an den Knoten anliegenden Pegeln eines Oszillatorsignals abgeleitet wird.

In entsprechender Weise weist eine Schaltungsanordnung gattungsgemäßer Art mit über Knoten 0 verbundenen, einen Oszillatorring bildenden Verzögerungselementen und mit einem in dem Oszillatorring angeordneten Torelement, welches mittels eines Steuersignals zum Öffnen oder Schließen des Torelements angesteuert ist, zur Unterdrückung von Schwingungsmoden, insbesondere von Schwingungsmoden höherer Ordnung, in dem Ringoszillator erfindungsgemäß eine Torsteuereinrichtung auf, welche dazu vorgesehen bzw. ausgebildet'ist, das vorerwähnte Steuersignal für das Torelement aus wenigstens einem der an den Knoten anliegenden Pegeln eines Oszillatorsignals abzuleiten.

In einer besonders vorteilhaften Verfahrensvariante ist vorgesehen, dass das Torelement nur dann mit dem Steuersignal zum Öffnen des Torelements angesteuert wird, wenn die an einer Anzahl vorbestimmter Knoten anliegenden Pegel einen jeweiligen vorbestimmten logischen Zustand aufweisen. Unerwünschte Zustände sind stets unerwünschten Schwingungsmoden zuzuordnen, so dass nur dann ein Weiteroszillieren stattfindet, wenn sichergestellt ist, dass nur erwünschte Zustände bzw. Schwingungsmoden "weitergereicht" werden.

Vorrichtungsmäßig ist die Torsteuereinrichtung der erfindungsgemäße Schaltungsanordnung in entsprechender Weise ausgebildet, das Torelement nur dann mit dem Steuersignal zum Öffnen des Torelements anzusteuern, wenn die an einer Anzahl vorbestimmter Knoten anliegenden Pegel einen jeweiligen vorbestimmten logischen Zustand (nämlich high oder low) aufweisen.

In weiterer Ausgestaltung dieser vorstehend angegebenen Verfahrensvariante ist erfindungsgemäß vorgesehen, dass das Torelement nur dann mit dem Steuersignal zum Öffnen des Torelements angesteuert wird, wenn die an einer Anzahl in regelmäßigen Abständen aufeinanderfolgender Knoten anliegenden Pegel einen jeweiligen vorbestimmten logischen Zustand (high oder low) aufweisen. Die Anzahl und die Art der Schwingungsmoden, die auftreten können, lässt sich bei dieser Variante in einfacher weise (vorher-)bestimmen und damit der entsprechende Oszillator in geeigneter Weise konfigurieren.

Die Torsteuereinrichtung der Schaltungsanordnung ist dementsprechend ausgebildet, das Torelement nur dann mit dem Steuersignal zum Öffnen des Torelements anzusteuern, wenn die an einer Anzahl in regelmäßigen Abständen aufeinanderfolgender Knoten anliegenden Pegel einen jeweiligen vorbestimmten logischen Zustand (high oder low) aufweisen.

Das erfindungsgemäße Verfahren zeichnet sich weiter Vorteilhafterweise dadurch aus, dass das Torelement nur dann mit dem Steuersignal zum Öffnen des Torelements angesteuert wird, wenn die an einer Anzahl in gleichen Abständen aufeinanderfolgender Knoten anliegenden Pegel einen jeweiligen vorbestimmten logischen Zustand (high oder low) aufweisen. Die Anzahl und die Art der Schwingungsmoden, die auftreten können, lässt sich bei dieser Variante in noch einfacher weise (vorher-)bestimmen und damit der entsprechende Oszillator in geeigneter Weise konfigurieren, insbesondere dann, wenn Verzögerungselemente identischer Art verwendet werden (Oszillator maximaler Symmetrie).

Bei der erfindungsgemäßen Schaltungsanordnung ist zur Realisierung dieses Verfahrens die Torsteuereinrichtung ausgebildet, das Torelement nur dann mit dem Steuersignal zum Öffnen des Torelements anzusteuern, wenn die an einer Anzahl in gleichen Abständen aufeinanderfolgender Knoten anliegenden Pegel einen jeweiligen vorbestimmten logischen Zustand (high oder low) aufweisen.

Der Grad der Überwachung wird dadurch weiter erhöht, dass das Torelement nur dann mit dem Steuersignal zum Öffnen des Torelements angesteuert wird, wenn die an einer Anzahl unmittelbar aufeinanderfolgender Knoten anliegenden Pegel einen jeweiligen vorbestimmten logischen Zustand (high oder low) aufweisen. Die Anzahl und die Auswahl der überwachten und zur'Erzeugung des Steuersignals herangezogenen Knoten bzw. Pegel hängt insbesondere von der Art und der Anzahl der gewünschten bzw. auszufilternden Schwingungsmoden ab.

Dem Verfahren entsprechend kann die Torsteuereinrichtung der Schaltungsanordnung der vorstehend genannten Art ausgebildet sein, das Torelement nur dann mit dem Steuersignal zum Öffnen des Torelements anzusteuern, wenn die an einer Anzahl unmittelbar aufeinanderfolgender Knoten anliegenden Pegel einen jeweiligen vorbestimmten logischen Zustand (high oder low) aufweisen.

Insbesondere zur Unterdrückung von Schwingungsmoden höherer Ordnung ist es vorteilhaft, wenn die jeweiligen vorbestimmten logischen Zustände (high oder low) für alle der Anzahl vorbestimmter Knoten insbesondere für alle der Anzahl in regelmäßigen Abständen aufeinanderfolgender Knoten, insbesondere für alle der Anzahl in gleichen Abständen aufeinanderfolgender Knoten, insbesondere für alle der Anzahl unmittelbar aufeinanderfolgender Knoten, identisch gewählt werden.

Bei der korrespondierenden Schaltungsanordnung ist demzufolge in entsprechender Weise vorgesehen, dass die jeweiligen vorbestimmten logischen Zustände (high oder low) für alle der Anzahl vorbestimmter Knoten, insbesondere für alle der Anzahl in regelmäßigen Abständen aufeinanderfolgender Knoten, insbesondere für alle der Anzahl in gleichen Abständen aufeinanderfolgender Knoten, insbesondere für alle der Anzahl unmittelbar aufeinanderfolgender Knoten, identisch sind.

Um die Anzahl überwachter Knoten gering zu halten, ist erfindungsgemäß vorgesehen, dass die Anzahl vorbestimmter Knoten kleiner als die Gesamtzahl aller Knoten gewählt wird.

Dabei ist insbesondere darauf zu achten, dass die vorbestimmten Knoten so gewählt werden, dass die Pegel der nicht vorbestimmten Knoten keinen unvorhersehbaren logischen Zustand (high oder low) einnehmen können.

Zur Erzeugung der Grundschwingung werden die vorbestimmten Knoten vorzugsweise so gewählt werden, dass sich auf einer Sequenz aufeinanderfolgender nicht vorbestimmter Knoten dauerhaft keine zwei Pegelübergähge von einem logischen Zustand (high oder low) in einen anderen logischen Zustand (high oder low) ausbilden können.

Die Erfindung wird nunmehr anhand der Zeichnung näher beschrieben. Es zeigen:
- Figur 1: Ein Ausführungsbeispiel eines Ringoszillators mit einer automatischen Torsteuerung gemäß der Erfindung,
- Figur 2: einen Aufbau eines Ringoszillators gemäß dem Stand der Technik mit Torelement zum Unterbinden unerwünschter Oszillationen. Das Torelement enthält ein Verzögerungselement. Über den Torsteuereingang kann ausgewählt werden, ob das Ausgangssignal des Torelements konstant oder von dessen Eingangssignal abhängig ist,
- Figur 3: einen Aufbau eines aus gleichartigen (vorzugsweise invertierenden) Verzögerungsstufen bestehenden Ringoszillators gemäß dem Stand der Technik. Der Ringoszillator weist maximale Symmetrie auf.

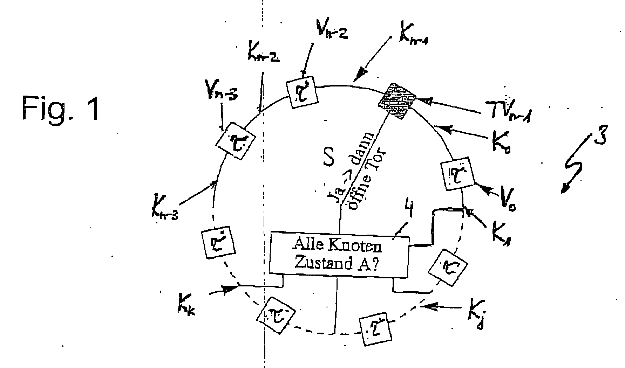

Zur Erläuterung der Erfindung wird nunmehr von der in Figur 1 gezeigten Schaltungsanordnung ausgegangen. Die Schaltungsanordnung nach der Figur 1 umfasst einen Ringoszillator 3 mit identischen, über Knoten K₀, K₁, ... Kⱼ ...Kₖ...Kₘ...Kₙ₋₁ verbundenen, einen Oszillatorring bildenden vorzugsweise invertierenden Verzögerungselementen V₀, V₁, ... Vⱼ ... Vₖ...Vₘ...Vₙ₋₁,TVₙ₋₁, wobei eines der Verzögerungselemente Vₙ₋₁ mit einem vorzugsweise invertierenden Torelement T, ein kombiniertes ggf. invertierendes Verzögerungs-/Torelement TVₙ₋₁ bildend, kombiniert ist, welches mittels eines Steuersignals S zum Öffnen oder Schließen des (kombinierten verzögerungs-/) Torelements TVₙ₋₁, angesteuert ist. Erfindungsgemäß ist eine Torsteuereinrichtung 4 vorgesehen. Diese Torsteuereinrichtung 4 ist ausgebildet, das Steuersignal S aus mehreren der an den Knoten K₀, K₁, ... Kⱼ...Kₖ...Kₘ...Kₙ₋₁ anliegenden Pegeln des Oszillatorsignals abzuleiten.

Zur Erklärung der Funktionsweise der Erfindung, nämlich der Ableitung des Steuersignals S zur Unterdrückung von Schwingungsmoden höherer Ordnung (außer der Grundmode) aus den an den Knoten anliegenden Pegeln sollen vorab noch einige Begriffe definiert werden:
1) Anfang des Rings
   Der Ausgang des Torelements TVₙ₋₁ bzw. eine beliebige Stelle in einem Oszillatorring ohne Torelement
2) Ende des Rings
   Der Eingang des Torelements TVₙ₋₁ bzw. der Eingang desjenigen Elements, dessen Ausgang der Anfang des Rings ist.
3) Zustand A: Der Zustand der Aus- und Eingänge der einzelnen Verzögerungselemente V₁, ... Vⱼ...Vₖ...Vₘ...Vₙ₋₁, TVₙ₋₁, wenn der Anfang und das Ende des Rings 3 den logischen Zustand "high" haben und sich nur die Grundmode im Ringoszillator 3 befindet.
4) Zustand B: Der Zustand der Aus- und Eingänge der einzelnen Verzögerungselemente V₁, ... Vⱼ...Vₖ...Vₘ...Vₙ₋₁,TVₙ₋₁, wenn der Anfang und das Ende des Rings 3 den logischen Zustand "low" haben und sich nur die Grundmode im Ringoszillator 3 befindet.
5) Knoten Kₘ
   Der Eingang des Verzögerungselements Vₘ (gleichbedeutend mit dem Ausgang des Verzögerungselements Vₘ₋₁ für alle m>=1).

Mit obigen Begriffsdefinitionen ergibt sich, dass im Grundmode entweder alle Knoten K₀, K₁, ... Kⱼ...Kₖ...Kₘ...Kₙ₋₁ den selben Zustand (A oder B) haben oder dass es genau einen Block aufeinanderfolgender Knoten Kⱼ...Kₖ gibt, die den Zustand A haben und einen Block aufeinanderfolgender Knoten, die den Zustand B haben. Haben alle Knoten K₀, K₁, ... Kⱼ...Kₖ...Kₘ...Kₙ₋₁ den Zustand A, so erhält Knoten K₀ nach einer Verzögerungszeit den Zustand B. Dieser Zustand Besetzt sich dann mit einer Verzögerungszeit nacheinander auf alle weiteren Knoten K₁, ... Kⱼ...Kₖ...Kₘ...Kₙ₋₁ fort. Hat Zustand B den Knoten Kₙ₋₁ erreicht, so haben alle Knoten K₀, K₁, ... Kⱼ.. .Kₖ...kₘ...Kₙ₋₁ den Zustand B. Nach einer Verzögerungszeit nimmt knoten K₀ dann wieder den Zustand A ein und dieser breitet sich in gleicher Weise aus.

Existiert ein höherer Schwingungsmode im Oszillatorring, so gibt es zu keiner Zeit den Fall, dass alle Knoten K₀, K₁, ..., Kⱼ...Kₖ...Kₘ...Kₙ₋₁ den selben Zustand aufweisen.

Im Grundmode ist es also nicht störend, Knoten K₀ so lange auf Zustand A zu setzen (unabhängig vom Zustand des Knotens Kₙ₋₁, bis alle Knoten bis zu einem bestimmten Knoten Kₖ den Zustand A angenommen haben und erst wenn diese Bedingung erfüllt ist, den Knoten K₀ wieder von Knoten Kₙ₋₁ abhängig zu machen. Wählt man für k den Wert (n-1), so ist sofort klar, dass sich kein höherer Schwingungsmode mehr ausbreiten kann. Dies kommt daher, dass dadurch erzwungen wird, dass alle Knoten den zustand A annehmen. Dies induziert somit sofort den Grundmode.

In der Praxis wird k etwas kleiner gewählt, damit die Verzögerung des Torelements T allein auf das Signal wirkt und nicht evtl. Verzögerungszeiten der Überwachungsschaltung.

Der Wert für k muss jedoch so groß gewählt werden, dass sich auf keinen Fall zwei Übergänge auf dem verbleibenden nicht überwachten Stück bis zum Ende des Rings 3 dauerhaft ausbilden können. Es ist aus dem gleichen Grund auch nicht nötig, alle Knoten K₀, K₁, ... Kⱼ...Kₖ des Bereichs von 0 bis k auf den Zustand A zu überwachen. Man kann sich darauf beschränken, nur jeden 2. oder 3. oder i. Knoten zu überwachen (je nach Reichweite des oben beschriebenen Sogeffekts). Der Anfang des überwachten Bereichs muss auch nicht Knoten K₀ sein, es kann auch Knoten Kⱼ sein. Dann muss sichergestellt sein, dass sich im nicht überwachten Bereich von k bis j keine zwei Übergänge dauerhaft ausbilden können.

Statt Zustand A kann im definierten Bereich natürlich auch Zustand B überwacht werden.

### Bezugszeichenliste

- 1: Ringoszillator
- 2: Ringoszillator mit Torelement
- 3: Ringoszillator mit pegelgesteuertem Torelement
- 4: Torsteuereinrichtung

- V₀: Verzögerungselement 0
- V₁: Verzögerungselement 1
- V₂: Verzögerungselement 2
- ...:
- Vₘ: Verzögerungselement m
- ...:
- Vₙ₋₁: Verzögerungselement n-1

- K₀: Knoten 0
- K₁: Knoten 1
- K₂: Knoten 2
- ...:
- Kⱼ: Knoten j
- Kₖ: Knoten k
- ...:
- Kₘ: Knoten m
- ...:
- Kₙ₋₁: Knoten n-1

- S: Steuersignal
- T: Torelement

- TVₙ₋₁: kombiniertes Tvr-/Verzögerungselement

- n: Anzahl der Verzögerungselemente
- j: Knotennummer
- k: Knotennummer
- m: Knotennummer
- τ: Verzögerungszeit

## Patentansprüche

1. Verfahren zur Unterdrückung von Schwingungsmoden, insbesondere von Schwingungsmoden höherer Ordnung, in einem Ringoszillator (3) mit ;über Knoten (K₀, K₁, ... Kⱼ ... Kₖ ... Kₘ ... Kₙ₋₁) verbundenen, einen Oszillatorring bildenden verzögerungselementen (V₀, V₁, ... Vⱼ ... Vₖ ... Vₘ ... Vₙ₋₁, TVₙ₋₁) und mit einem in dem Oszillatorring angeordneten Torelement (T, TVₙ₋₁), welches mittels eines Steuersignals (S) zum Öffnen oder Schließen des Torelements (T, TVₙ₋₁) angesteuert wird,
**dadurch gekennzeichnet, dass**
das Steuersignal (S) aus wenigstens einem der an den Knoten (K₀, K₁, ... Kⱼ... Kₖ...Kₘ...Kₙ₋₁) anliegenden Pegeln eines Oszillatorsignals abgeleitet wird.

2. Verfahren nach Anspruch 1,
**dadurch gekennzeichnet, dass**
das Torelement (T, TVₙ₋₁) nur dann mit dem Steuersignal (S) zum Öffnen des Torelements (T, TVₙ₋₁) angesteuert wird, wenn die an einer Anzahl (k) vorbestimmter Knoten (K₁, ... Kⱼ...Kₖ) anliegenden Pegel einen jeweiligen vorbestimmten logischen Zustand (high, low) aufweisen.

3. Verfahren nach Anspruch 2,
**dadurch gekennzeichnet, dass**
das Torelement (T, TVₙ₋₁) nur dann mit dem Steuersignal (S) zum Öffnen des Torelements (T, TVₙ₋₁) angesteuert wird, wenn die an einer Anzahl (k) in regelmäßigen Abständen aufeinanderfolgender Knoten (K₁, ... Kⱼ ... Kₖ) anliegenden Pegel einen jeweiligen vorbestimmten logischen Zustand (high, low) aufweisen.

4. Verfahren nach Anspruch 3,
**dadurch gekennzeichnet, dass**
das Torelement (T, TVₙ₋₁) nur dann mit dem Steuersignal (S) zum Öffnen des Torelements (T, TVₙ₋₁) angesteuert wird, wenn die an einer Anzahl (k) in gleichen Abständen aufeinanderfolgender Knoten (K₁, ... Kⱼ...Kₖ) anliegenden Pegel einen jeweiligen vorbestimmten logischen Zustand (high, low) aufweisen.

5. Verfahren nach Anspruch 4,
**dadurch gekennzeichnet, dass**
das Torelement (T, TVₙ₋₁) nur dann mit dem Steuersignal (S) zum Öffnen des Torelements (T, TVₙ₋₁) angesteuert wird, wenn die an einer Anzahl (k) unmittelbar aufeinanderfolgender Knoten (K₁, ... Kⱼ...Kₖ) anliegenden Pegel einen jeweiligen vorbestimmten logischen Zustand (high, low) aufweisen.

6. Verfahren nach einem der Ansprüche 2 bis 5,
**dadurch gekennzeichnet, dass**
die jeweiligen vorbestimmten logischen Zustände (high, low) für alle der Anzahl (k) vorbestimmter Knoten (K₁, ... Kⱼ...Kₖ), insbesondere für alle der Anzahl (k) in regelmäßigen Abständen aufeinanderfolgender Knoten (K₁, ... Kⱼ...Kₖ), insbesondere für alle der Anzahl (k) in gleichen Abständen aufeinanderfolgender Knoten (K₁, ... Kⱼ ... Kₖ), insbesondere für alle der Anzahl (k) unmittelbar aufeinanderfolgender Knoten (K₁, ··· Kⱼ ... Kₖ), identisch gewählt werden.

7. Verfahren nach einem der Ansprüche 2 bis 6,
**dadurch gekennzeichnet, dass**
die Anzahl (k) vorbestimmter Knoten (K₁, ... Kⱼ ... Kₖ) kleiner als die Gesamtzahl (n) aller Knoten (K₀, K₁, ... Kⱼ ... Kₖ ... Kₘ ... Kₙ₋₁) gewählt wird.

8. Verfahren nach einem der Ansprüche 2 bis 7,
**dadurch gekennzeichnet, dass**
die vorbestimmten Knoten (K₁, ... Kⱼ ... Kₖ) so gewählt werden, dass die Pegel der nicht vorbestimmten Knoten (K₀, Kₖ₊₁, ... Kₙ₋₁) keinen unvorhersehbaren logischen Zustand (high, low) einnehmen können.

9. Verfahren nach Anspruch 8,
**dadurch gekennzeichnet, dass**
die vorbestimmten Knoten (K₁, ... Kⱼ...Kₖ) so gewählt werden, dass sich auf einer Sequenz aufeinanderfolgender nicht vorbestimmter Knoten (Kₖ₊1, ... Kₙ₋₁) dauerhaft keine zwei Pegelübergänge von einem logischen Zustand (high, low) in einen anderen logischen zustand (high, low) ausbilden können.

10. Schaltungsanordnung zur Unterdrückung von Schwingungsmoden, insbesondere von Schwingungsmoden höherer Ordnung, in einem Ringoszillator (3) mit über Knoten (K₀, K₁, ... Kⱼ...Kₖ...Kₘ...Kₙ₋₁) verbundenen, einen Oszillatorring bildenden Verzögerungselementen (V₀, V₁, ... Vⱼ...Vₖ...Vₘ...Vₙ₋₁, TVₙ₋₁) und mit einem in dem Oszillatorring angeordneten Torelement (T, TVₙ₋₁), welches mittels eines Steuersignals (S) zum Öffnen oder Schließen des Torelements (T, TVₙ₋₁) angesteuert ist,
**dadurch gekennzeichnet, dass**
eine Torsteuereinrichtung (4) vorgesehen ist, welche dazu vorgesehen ist, das Steuersignal (S) aus wenigstens einem der an den Knoten (K₀, K₁, ... Kⱼ, ...Kₖ ...Kₘ...Kₙ₋₁) anliegenden Pegeln eines Oszillatorsignals abzuleiten.

11. Schaltungsanordnung nach Anspruch 10,
**dadurch gekennzeichnet, dass**
die Torsteuereinrichtung (4) ausgebildet ist, das Torelement (T, TVₙ₋₁) nur dann mit dem Steuersignal (S) zum Öffnen des Torelements (T, TVₙ₋₁) anzusteuern, wenn die an einer Anzahl (k) vorbestimmter Knoten (K₁, ... Kⱼ ... Kₖ) anliegenden Pegel einen jeweiligen vorbestimmten logischen Zustand (high, low) aufweisen.

12. Schaltungsanordnung nach Anspruch 2,
**dadurch gekennzeichnet, dass**
die Torsteuereinrichtung (4) ausgebildet ist, das Torelement (T, TVₙ₋₁) nur dann mit dem Steuersignal (S) zum Öffnen des Torelements (T, TVₙ₋₁) anzusteuern, wenn die an einer Anzahl (k) regelmäßigen Abständen aufeinanderfolgender Knoten (K₁, ... Kⱼ...Kₖ) anliegenden Pegel einen jeweiligen vorbestimmten logischen Zustand (high, low) aufweisen.

13. Schaltungsanordnung nach Anspruch 12,
**dadurch gekennzeichnet, dass**
die Torsteuereinrichtung (4) ausgebildet ist, das Torelement (T, TVₙ₋₁) nur dann mit dem Steuersignal (S) zum Öffnen des Torelements (T, TVₙ₋₁) anzusteuern, wenn die an einer Anzahl (k) in gleichen Abständen aufeinanderfolgender Knoten (K₁, ... Kⱼ...Kₖ) anliegenden Pegel einen jeweiligen vorbestimmten logischen Zustand (high, low) aufweisen.

14. Schaltungsanordnung nach Anspruch 13,
**dadurch gekennzeichnet, dass**
die Torsteuereinrichtung (4) ausgebildet ist, das Torelement (T, TVₙ₋₁) nur dann mit dem Steuersignal (S) zum Öffnen des Torelements (T, TVₙ₋₁) anzusteuern, wenn die an einer Anzahl (k) unmittelbar aufeinanderfolgender Knoten (K₁, ... Kⱼ.. Kₖ) anliegenden Pegel einen jeweiligen vorbestimmten logischen Zustand (high, low) aufweisen.

15. Schaltungsanordnung nach einem der Ansprüche 11 bis 14,
**dadurch gekennzeichnet, dass**
die jeweiligen vorbestimmten logischen Zustände (high, low) für alle der Anzahl (k) vorbestimmter Knoten (K₁, ... Kⱼ... Kₖ), insbesondere für alle der Anzahl (k) in regelmäßigen Abständen aufeinanderfolgender Knoten (K₁, ... Kⱼ..Kₖ), insbesondere für alle der Anzahl (k) in gleichen Abständen aufeinanderfolgender Knoten (K₁, ... Kⱼ...Kₖ), insbesondere für alle der Anzahl (k) unmittelbar aufeinanderfolgender Knoten (K₁, ... Kⱼ...Kₖ), identisch sind.

16. Schaltungsanordnung nach einem der Ansprüche 11 bis 15,
**dadurc**h **gekennzeichnet, dass**
die Anzahl (k) vorbestimmter Knoten (K₁, ... Kⱼ...Kₖ) kleiner als die Gesamtzahl (n) aller Knoten (K₀, K₁, ... Kⱼ...Kₖ...Kₘ...Kₙ₋₁) ist.

17. Schaltungsanordnung nach einem der Ansprüche 11 bis 16,
**dadurch gekennzeichnet, dass**
die vorbestimmten Knoten (K₁, ... Kⱼ...Kₖ) so gewählt sind, dass die Pegel der nicht vorbestimmten Knoten (K₀, Kₖ₊₁, ... Kₙ₋₁) keinen unvorhersehbaren logischen Zustand (high, low) einnehmen können.

18. Schaltungsanordnung nach Anspruch 17,
**dadurch gekennzeichnet, dass**
die vorbestimmten Knoten (K₁, ... Kⱼ....Kₖ) so gewählt sind, dass sich auf einer Sequenz aufeinanderfolgender nicht vorbestimmter Knoten (Kₖ₊₁, ... Kₙ₋₁) dauerhaft keine zwei Pegelübergänge von einem logischen Zustand (high, low) in einen anderen logischen Zustand (high, low) ausbilden können.
